(19) Europäisches Patentamt
European Patent Office
Office européen des brevets

(11) **EP 2 270 977 A1**

(12) **DEMANDE DE BREVET EUROPEEN**

(43) Date de publication:
**05.01.2011 Bulletin 2011/01**

(51) Int Cl.:
*H03F 3/00* (2006.01)       *H03F 3/45* (2006.01)

(21) Numéro de dépôt: **10164856.6**

(22) Date de dépôt: **03.06.2010**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**
Etats d'extension désignés:
**BA ME RS**

(30) Priorité: **17.06.2009  FR 0954071**

(71) Demandeur: **STMicroelectronics (Grenoble 2) SAS**
**38000 Grenoble (FR)**

(72) Inventeurs:
• **Sabut, Marc**
  **38320 Eybens (FR)**
• **Gicquel, Hugo**
  **38000 Grenoble (FR)**
• **Reaute, Fabien**
  **38140 Renage (FR)**

(74) Mandataire: **Zapalowicz, Francis**
  **Casalonga & Partners**
  **Bayerstrasse 71/73**
  **80335 München (DE)**

(54) **Procédé et dispositif de contrôle d'une tension de mode commun d'un système à capacités commutées, en particulier un convertisseur analogique/numérique**

(57)     Procédé de contrôle d'une tension de mode commun d'un système à capacités commutées, comprenant une détermination de la tension courante de mode commun du système à capacités commutées, une conversion dans une cellule transconductrice (CEL), de la différence entre la tension courante de mode commun et une tension de mode commun désirée (VCM) en un courant résultant et une réinjection de ce courant résultant dans le système à capacités commutées (SCM) par l'intermédiaire d'un chemin résistif (R1, R2).

## FIG.1

**Description**

L'invention concerne les circuits intégrés, et plus particulièrement le contrôle d'un niveau de mode commun d'un système à capacités commutées, en particulier un convertisseur analogique/numérique à capacités commutées.

Dans un système à capacités commutées, par exemple un convertisseur analogique/numérique à capacités commutées, le mode commun d'entrée est obtenu, selon l'art antérieur, par l'utilisation d'un générateur de tension générant la tension de mode commun désirée, et par un jeu de deux résistances externes connectées entre la sortie du générateur et les entrées différentielles du convertisseur analogique/numérique. Cependant, une telle réalisation souffre d'une chute de tension au niveau des résistances externes en raison de la consommation de courant aux noeuds d'entrée du convertisseur analogique/numérique. Cette consommation provient des courants de fuite lors des commutations successives du système à capacités commutées et/ou du courant de substrat (« Bulk ») dans les transistors utilisés comme commutateurs.

De ce fait, la tension de mode commun aux entrées du convertisseur analogique/numérique peut être significativement différente de la tension de mode commun désirée, cette différence pouvant être de l'ordre de quelques centaines de millivolts.

Selon un mode de mise en oeuvre et de réalisation, il est proposé un procédé et un dispositif de contrôle permettant d'asservir la tension de mode commun aux entrées différentielles du système à capacités commutées sur la tension de mode commun désirée.

Selon un autre mode de mise en oeuvre et de réalisation, il est proposé également de rendre un tel asservissement indépendant de la fréquence de commutation des commutateurs du système à capacités commutées.

Selon un aspect, il est proposé un procédé de contrôle d'une tension de mode commun d'un système à capacité commutée, comprenant une détection de la tension courante de mode commun du système à capacités commutées, une conversion, dans une cellule transconductrice, de la différence entre la tension courante de mode commun et une tension de mode commun désirée en un courant résultant, et une réinjection de ce courant résultant dans le système à capacités commutées par l'intermédiaire d'un chemin résistif.

Ainsi, selon cet aspect, on asservit la tension courante de mode commun sur la tension désirée ou tension de consigne, en compensant le courant absorbé par le système à capacités commutées.

Selon un mode de mise en oeuvre, il est particulièrement avantageux d'effectuer ladite conversion avec une cellule transconductrice ayant une transconductance proportionnelle à la fréquence de commutation du système à capacités commutées. En effet, ceci permet d'obtenir un gain en tension indépendant de la fréquence de commutation. Par ailleurs, ce gain maintenu constant est avantageusement choisi suffisamment haut pour maintenir une erreur de gain statique basse quel que soit le courant absorbé par le système à capacités commutées.

L'invention s'applique avantageusement mais non limitativement au contrôle de la tension de mode commun d'un convertisseur analogique/numérique à capacités commutées.

Selon un autre aspect, il est proposé un dispositif de contrôle d'une tension de mode commun d'un système à capacités commutées, comprenant

-   des moyens de détection configurés pour délivrer la tension courante de mode commun du système à capacités commutées,
-   des moyens de génération configurés pour générer une tension de mode commun désirée,
-   une cellule transconductrice possédant une première entrée de cellule couplée à la sortie des moyens de détection, une deuxième entrée de cellule couplée à la sortie des moyens de génération et une sortie de cellule rebouclée sur le système à capacités commutées par l'intermédiaire d'un chemin résistif.

Selon un mode de réalisation, la transconductance de la cellule transconductrice est proportionnelle à la fréquence de commutation du système à capacités commutées.

Selon un mode de réalisation, la cellule transconductrice comprend un étage transconducteur possédant une première entrée et une deuxième entrée respectivement couplées à la première entrée de cellule et à la deuxième entrée de cellule, et des moyens supplémentaires couplés à ladite deuxième entrée et configurés pour émuler le courant absorbé par le système à capacité commutées compte tenu de la fréquence de commutation.

Selon un mode de réalisation, les moyens supplémentaires comprennent un condensateur couplé à ladite deuxième entrée de l'étage transconducteur, dont la valeur capacitive est proportionnelle à la valeur capacitive d'entrée du système à capacité commutées et des moyens de commande configurés pour successivement charger et décharger le condensateur à ladite fréquence de commutation.

Selon un mode de réalisation, la cellule transconductrice comporte un transistor dont l'électrode de commande forme ladite deuxième entrée de cellule, et les moyens de génération comportent un pont résistif dont le point milieu est connecté à l'électrode de commande du transistor.

Selon un mode de réalisation, les moyens de détection comprennent un réseau capacitif possédant deux bornes et un point milieu connecté à la masse et des moyens de gestion configurés pour relier les deux bornes du réseau capacitif aux bornes d'entrée du système à capacités commutées, puis pour court-circuiter le réseau capacitif en reliant ensemble les deux bornes du réseau capacitif, les deux bornes ainsi reliées formant la sortie des moyens de détection.

Un tel mode de réalisation permet d'obtenir des moyens de détection qui ne consomment pas de courant en n'apportant pas d'impédance sur les noeuds d'entrée du système à capacités commutées. Par ailleurs, de tels moyens de détection n'apportent pas de bruit dans la détection du signal.

Selon un autre aspect, il est proposé un convertisseur analogique/numérique à capacités commutées comprenant un dispositif de contrôle tel que défini ci-avant.

Selon encore un autre aspect, il est proposé un appareil de communication sans fil, par exemple un téléphone mobile cellulaire comportant un convertisseur analogique/numérique tel que défini ci-avant.

D'autres avantages et caractéristiques de l'invention apparaîtront à l'examen de la description détaillée de modes de mise en oeuvre et de réalisation, nullement limitatifs, et des dessins annexés sur lesquels :

- la figure 1 illustre très schématiquement un mode de réalisation d'un dispositif de contrôle selon l'invention permettant une mise en oeuvre d'un procédé de contrôle selon l'invention ;
- la figure 2 illustre plus en détails et toujours schématiquement un exemple de réalisation de moyens de détection de la tension courante de mode commun ;
- la figure 3 illustre plus en détails un exemple de réalisation d'une cellule transconductrice d'un dispositif de contrôle selon l'invention ; et
- la figure 4 illustre schématiquement un exemple de générateur d'une tension de mode commun désirée.

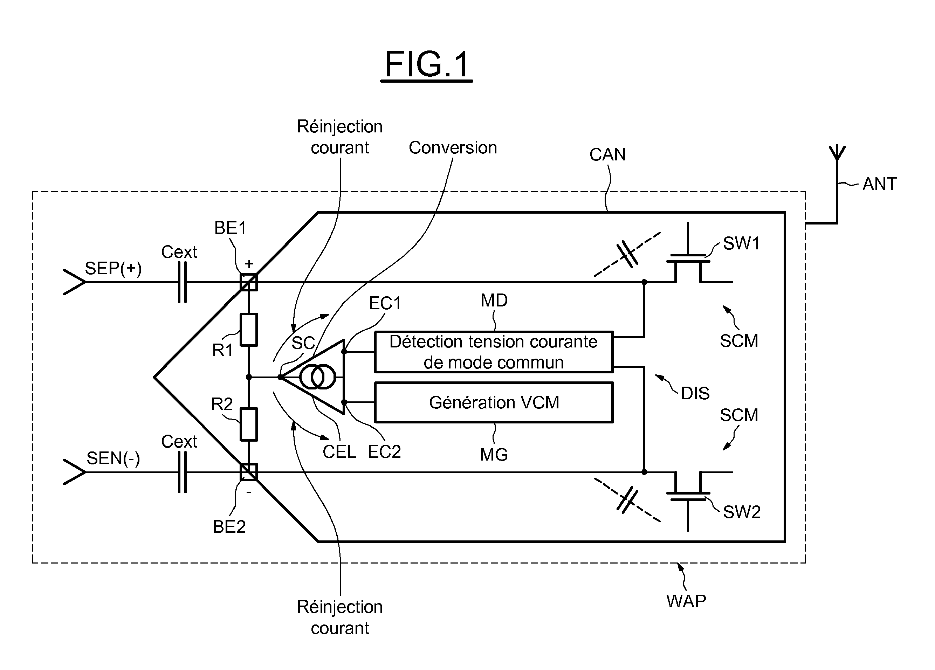

Sur la figure 1, la référence CAN désigne un convertisseur analogique/numérique comportant un système à capacités commutées SCM.

Ce convertisseur analogique/numérique est par exemple incorporé au sein de la chaîne de réception d'un appareil de communication sans fil WAP, par exemple un téléphone mobile cellulaire, équipé d'une antenne ANT.

Le convertisseur analogique/numérique reçoit un signal d'entrée, ici un signal d'entrée différentiel SEP, SEN sur les deux bornes d'entrée BE1 et BE2 du convertisseur CAN. Les condensateurs Cext matérialisent les capacités externes au convertisseur CAN.

Le convertisseur CAN incorpore un dispositif DIS visant à contrôler la tension de mode commun d'entrée du système à capacités commutées du convertisseur CAN.

Ce dispositif DIS comporte des moyens MD configurés pour détecter (déterminer) la tension courante de mode commun du système à capacités commutées SCM, ainsi que des moyens de génération MG configurés pour générer une tension de mode commun désirée, ou tension de consigne, VCM.

Le dispositif DIS comporte par ailleurs une cellule transconductrice CEL possédant une première entrée de cellule EC1 pour recevoir la tension courante de mode commun, et une deuxième entrée de cellule EC2 pour recevoir la tension de consigne VCM.

La cellule transconductrice possède également une sortie de cellule SC rebouclée sur les deux bornes d'entrée BE1 et BE2, et par conséquent sur le système à capacités commutées SCM, par l'intermédiaire d'un chemin résistif comportant ici deux résistances R1 et R2.

Ainsi, en fonctionnement, la cellule transconductrice CEL effectue une conversion de la différence entre la tension courante de mode commun du système à capacités commutées et la tension de mode commun désirée VCM, en un courant résultant. On réinjecte ensuite ce courant résultant dans le système à capacités commutées par l'intermédiaire du chemin résistif R1, R2.

En d'autres termes, on réalise ici un asservissement de la tension courante de mode commun du système à capacités commutées, et par conséquent du convertisseur CAN, sur la tension de consigne VCM, avec une compensation du courant absorbé par le convertisseur analogique/numérique.

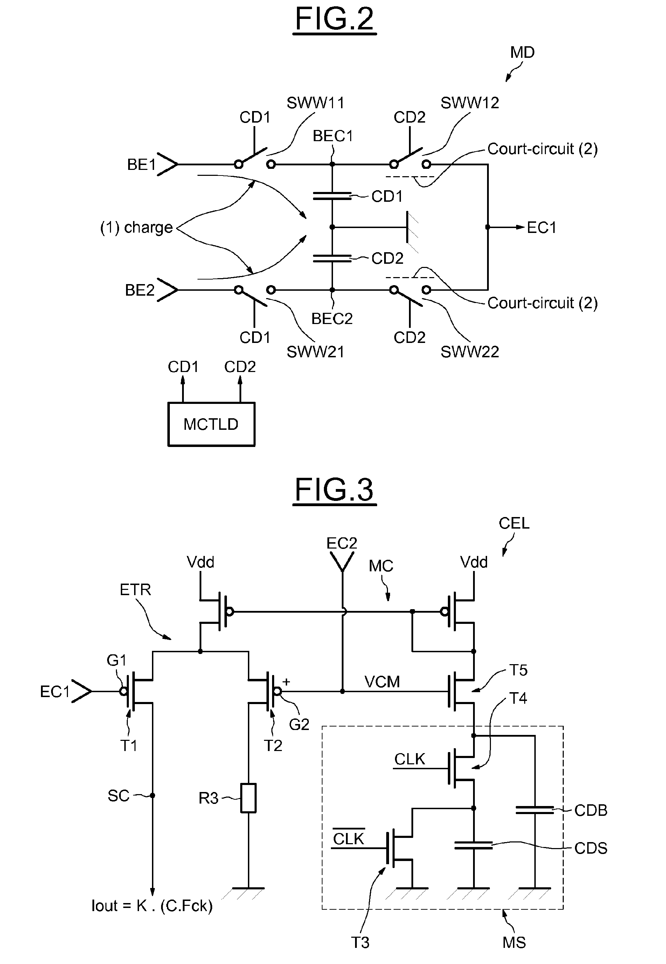

Bien que plusieurs solutions soient possibles pour réaliser les moyens de détection MD, en particulier l'utilisation d'un pont résistif, il est particulièrement avantageux d'utiliser le mode de réalisation illustré sur la figure 2.

Plus précisément, les moyens de détection MD comportent ici un réseau capacitif comportant deux condensateurs CD1 et CD2 possédant chacun une borne reliée à la masse. L'autre borne BEC1 du condensateur CD1 est reliée à la borne d'entrée BE1 par l'intermédiaire d'un commutateur SWW11 commandé par un signal de commande CD1.

L'autre borne BEC2 du condensateur CD2 est reliée à la borne BE2 par l'intermédiaire d'un commutateur SWW21 commandé également par le signal de commande CD1.

Par ailleurs, la borne BEC1 est également connectée à la première entrée de cellule EC1 par l'intermédiaire d'un commutateur SWW12 commandé par un signal de commande CD2.

La borne BEC2 est également connectée à l'entrée de cellule EC1 par l'intermédiaire d'un commutateur SWW22 également commandé par le signal de commande CD2.

Un bloc de contrôle MCTLD, réalisé par exemple à l'aide de circuits logiques, est configuré pour délivrer les signaux logiques de commande CD1 et CD2. Le bloc MCTLD ainsi que les différents commutateurs SWW11, SWW12, SWW21 et SWW22 forment des moyens de gestion qui sont configurés pour, dans un premier temps, relier les deux bornes BEC1, BEC2 du réseau capacitif CD1, CD2 aux bornes d'entrée BE1, BE2 du convertisseur CAN (commutateurs SWW11 et SWW21 fermés et commutateurs SWW12 et SWW22 ouverts) puis, dans un deuxième temps, pour court-circuiter le réseau capacitif CD1, CD2 en reliant ensemble les deux bornes BEC1, BEC2 de ce réseau capacitif (commutateurs SWW12 et SWW22 fermés et commutateurs SWW11 et SWW21 ouverts). Les deux bornes BEC1 et BEC2, ainsi reliées, forment donc la sortie des moyens de détection MD.

La fréquence de commutation des commutateurs des moyens MD est égale à la fréquence de commutation Fck du système à capacités commutées.

Ainsi, dans la phase 1, il y a une charge des deux condensateurs CD1 et CD2 puis, dans la phase 2, un échange de charge entre les deux condensateurs, provoqué par le court-circuit de ceux-ci.

Dans la deuxième phase, les deux bornes BEC1 et BEC2, reliées ensemble, délivrent la tension courante de mode commun.

Un tel mode de réalisation ne présente pas d'impédance sur les bornes BE1 et BE2. Il n'en résulte donc aucune consommation de courant. En outre, un tel dispositif n'apporte pas de bruit sur le signal.

Le courant absorbé par le convertisseur analogique/numérique est proportionnel à la fréquence de commutation Fck des capacités du système à capacités commutées SCM. Plus précisément, ce courant i est égal à :

$$Vcm / (1/ C \bullet Fck) \qquad (I)$$

dans laquelle Vcm désigne la tension courante de mode commun, C désigne la valeur capacitive du système à capacités commutées et Fck la fréquence de commutation du système à capacités commutées.

Il est donc particulièrement avantageux que la cellule transconductrice CEL puisse avoir une transconductance proportionnelle à la fréquence de commutation du système à capacités commutées, de façon à maintenir un gain en tension constant.

Le mode de réalisation de la figure 3 permet d'offrir une cellule transconductrice CEL ayant une transconductance proportionnelle à la fréquence Fck.

Plus précisément, cette cellule CEL comporte un étage transconduteur ETR possédant deux transistors PMOS T1 et T2 dont les grilles G1 et G2 forment respectivement une première entrée et une deuxième entrée respectivement couplées à la première entrée de cellule EC1 et à la deuxième entrée de cellule EC2.

La cellule transconductrice CEL comporte par ailleurs des moyens supplémentaires MS couplés à la grille G2 et configurés pour émuler le courant absorbé par le système à capacités commutées compte tenu de la fréquence de commutation.

Plus précisément, les moyens supplémentaires MS comprennent ici un condensateur CDS dont la valeur capacitive est proportionnelle à la valeur capacitive d'entrée du système à capacités commutées. On pourra par exemple prendre une valeur capacitive pour le condensateur CDS environ 20 à 50 fois plus petite que la valeur capacitive d'entrée du système à capacités commutées.

Par ailleurs, le condensateur CDS est destiné à être successivement chargé et déchargé à la fréquence de commutation Fck par des moyens de commande comportant ici deux transistors NMOS T3 et T4 fonctionnant en commutateurs, et respectivement commandés par des signaux de commande $\overline{CLK}$ et CLK au rythme de la fréquence de commutation Fck. Les moyens MS comportent par ailleurs un condensateur CDB formant ballast, et destiné à créer un générateur de tension parfait.

Le condensateur CDS est connecté à la grille G2 du transistor T2 par l'intermédiaire d'un transistor NMOS T5.

Enfin, la cellule CEL comporte un miroir de courant MC.

Le courant de sortie Iout de la cellule CEL est proportionnel au produit C•Fck où C désigne la capacité du système à capacités commutées.

Par conséquent, puisque ce courant de sortie est proportionnel à la fréquence de commutation Fck, la transconductance Gm de cette cellule est également proportionnelle à la fréquence de commutation.

Le gain en tension est défini par la formule (II) ci-dessous :

$$Gain = Gm\left(\frac{1}{C \bullet Fck}\right) \qquad (II)$$

Cette formule (II) peut également s'écrire sous la forme suivante :

$$\text{Gain} = \frac{\alpha \cdot \text{Iout}}{(\text{Vgs} - \text{Vt})} \text{x} \left( \frac{1}{\text{C} \bullet \text{Fck}} \right) \qquad (\text{III})$$

dans laquelle $\alpha$ désigne un coefficient de proportionnalité fonction de la technologie utilisée (1.3<$\alpha$<2), Vgs est la tension grille source du transistor T1 et Vt la tension de seuil,
ou encore par la formule (IV) ci-dessous :

$$\text{Gain} = \frac{\alpha \cdot \text{K} \cdot (\text{C} \bullet \text{Fck})}{(\text{Vgs} - \text{Vt})} \text{x} \left( \frac{1}{\text{C} \bullet \text{Fck}} \right) \qquad (\text{IV})$$

dans laquelle K est fonction de la tension VCM et de la tension Vgs du transistor T5 (K=VCM-Vgs(T5)).
On voit donc que, dans cette formule (IV), les termes C•Fck s'annulent, ce qui rend le gain en tension indépendant de la fréquence de commutation Fck.
Par ailleurs, on choisira avantageusement ce gain suffisamment élevé pour maintenir une faible erreur statique en gain quelle que soit la valeur du courant absorbé par le convertisseur analogique/numérique. Une valeur de 50 à 100 est largement suffisante.

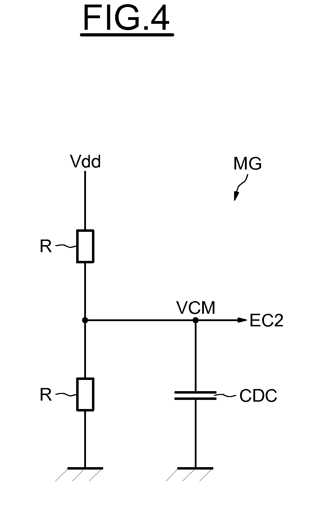

La figure 4 illustre un mode possible de réalisation de moyens de génération de la tension de consigne VCM. Plus précisément, un simple diviseur de tension réalisé par un pont résistif R,R connecté entre la tension d'alimentation Vdd et la masse, permet de délivrer la tension VCM puisque aucun courant n'est tiré de ces moyens MG car il ne sont connectés que sur des grilles de transistors. Le condensateur CDC est un condensateur de découplage qui permet de s'affranchir des variations haute fréquence d'alimentation.

**Revendications**

1. Procédé de contrôle d'une tension de mode commun d'un système à capacités commutées, comprenant une détermination de la tension courante de mode commun du système à capacités commutées, une conversion dans une cellule transconductrice (CEL), de la différence entre la tension courante de mode commun et une tension de mode commun désirée (VCM) en un courant résultant et une réinjection de ce courant résultant dans le système à capacités commutées (SCM) par l'intermédiaire d'un chemin résistif (R1, R2).

2. Procédé selon la revendication 1, dans lequel on effectue ladite conversion avec une cellule transconductrice (CEL) ayant une transconductance proportionnelle à la fréquence de commutation du système à capacités commutées.

3. Procédé selon l'une des revendications précédentes, dans lequel on contrôle ladite tension de mode commun d'un convertisseur analogique/numérique à capacités commutées (CAN).

4. Dispositif de contrôle d'une tension de mode commun d'un système à capacités commutées, comprenant des moyens de détection (MD) configurés pour délivrer la tension courante de mode commun du système à capacités commutées, des moyens de génération (MG) configurés pour générer une tension de mode commun désirée, une cellule transconductrice (CEL) possédant une première entrée de cellule couplée à la sortie des moyens de détection, une deuxième entrée de cellule couplée à la sortie des moyens de génération et une sortie de cellule rebouclée sur le système à capacités commutées par l'intermédiaire d'un chemin résistif (R1, R2).

5. Dispositif selon la revendication 4, dans lequel la transconductance de la cellule transconductrice (CEL) est proportionnelle à la fréquence de commutation du système à capacités commutées.

6. Dispositif selon la revendication 5, dans lequel la cellule transconductrice (CEL) comprend un étage transconducteur (ETR) possédant une première entrée et une deuxième entrée respectivement couplées à la première entrée de cellule et à la deuxième entrée de cellule, et des moyens supplémentaires (MS) couplés à ladite deuxième entrée et configurés pour émuler le courant absorbé par le système à capacité commutées compte tenu de la fréquence de commutation.

7. Dispositif selon la revendication 6, dans lequel les moyens supplémentaires (MS) comprennent un condensateur (CDS) couplé à ladite deuxième entrée de l'étage transconducteur, dont la valeur capacitive est proportionnelle à la valeur capacitive d'entrée du système à capacité commutées et des moyens de commande (T3, T4) configurés pour successivement charger et décharger le condensateur à ladite fréquence de commutation.

8. Dispositif selon l'une des revendications 4 à 7, dans lequel la cellule transconductrice (CEL) comporte un transistor (T2) dont l'électrode de commande forme ladite deuxième entrée de cellule, et les moyens de génération (MG) comportent un pont résistif (R, R) dont le point milieu est connecté à l'électrode de commande du transistor.

9. Dispositif selon l'une des revendications 4 à 8, dans lequel les moyens de détection (MD) comprennent un réseau capacitif (CD1, CD2) possédant deux bornes et un point milieu connecté à la masse et des moyens de gestion (MCTLD) configurés pour relier les deux bornes du réseau capacitif aux bornes d'entrée du système à capacités commutées, puis pour court-circuiter le réseau capacitif en reliant ensemble les deux bornes du réseau capacitif, les deux bornes ainsi reliées formant la sortie des moyens de détection.

10. Convertisseur analogique/numérique à capacités commutées, comprenant un dispositif selon l'une des revendications 4 à 9.

11. Appareil de communication sans fil, comportant un convertisseur analogique/numérique selon la revendication 10.

EP 2 270 977 A1

FIG.1

7

## FIG.2

MD

CD1  SWW11     CD2  SWW12
        BEC1
BE1                           Court-circuit (2)

(1) charge

CD1

CD2                           EC1

BE2                           Court-circuit (2)
        BEC2
CD1  SWW21      CD2  SWW22

CD1   CD2

MCTLD

## FIG.3

CEL

EC2

Vdd        MC        Vdd

ETR

VCM

G1                           T5
EC1                          T4
            +
T1      G2
        T2

            CLK

SC      R3                   CDB

        CLK                  CDS

Iout = K . (C.Fck)

T3        MS

# FIG.4

Vdd

MG

R

VCM

EC2

R

CDC

Europäisches
Patentamt

European
Patent Office

Office européen
des brevets

# RAPPORT DE RECHERCHE EUROPEENNE

Numéro de la demande

EP 10 16 4856

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 7 405 625 B1 (HENSLEY JOSEPH MICHAEL [US] ET AL) 29 juillet 2008 (2008-07-29) * colonne 3, ligne 29 - colonne 5, ligne 27; figure 2 * ----- | 1-11 | INV. H03F3/00 H03F3/45 |
| A | US 4 697 152 A (WESTWICK ALAN L [US]) 29 septembre 1987 (1987-09-29) * colonne 2, ligne 25 - colonne 4, ligne 2; figure 1 * ----- | 1-11 | |
| A | US 6 191 622 B1 (WATSON MINH [US]) 20 février 2001 (2001-02-20) * colonne 2, ligne 54 - colonne 4, ligne 11; figures 1a,1b,1c * ----- | 1-11 | |
| A | US 2004/021511 A1 (MICHALSKI CHRISTOPHER [US]) 5 février 2004 (2004-02-05) * alinéa [0018] - alinéa [0036]; figure 3 * ----- | 1-11 | |
| A | US 2008/074189 A1 (SINGH PRATAP N [IN] ET AL) 27 mars 2008 (2008-03-27) * alinéa [0006] - alinéa [0007]; figure 3 * ----- | 1-11 | DOMAINES TECHNIQUES RECHERCHES (IPC) H03F |

Le présent rapport a été établi pour toutes les revendications

| Lieu de la recherche | Date d'achèvement de la recherche | Examinateur |
|---|---|---|
| Munich | 20 septembre 2010 | Lorenzo, Carlos |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 16 4856

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-09-2010

| Document brevet cité<br>au rapport de recherche | | Date de<br>publication | Membre(s) de la<br>famille de brevet(s) | Date de<br>publication |
|---|---|---|---|---|
| US 7405625 | B1 | 29-07-2008 | AUCUN | |
| US 4697152 | A | 29-09-1987 | AUCUN | |
| US 6191622 | B1 | 20-02-2001 | AUCUN | |
| US 2004021511 | A1 | 05-02-2004 | AUCUN | |
| US 2008074189 | A1 | 27-03-2008 | AUCUN | |

EPO FORM P0460

Pour tout renseignement concernant cette annexe : voir Journal Officiel de l'Office européen des brevets, No.12/82